# EUROPEAN PATENT APPLICATION

(11) **EP 2 536 026 A1**
(43) Date of publication of application: **19.12.2012**
(21) Application number: 11832080.3
(22) Date of filing: 27.10.2011
(51) Int. Cl.: H03F 3/21

(54) **POWER AMPLIFICATION TUBE AND POWER AMPLIFICATION METHOD**

(30) Priority: 29.04.2011 CN 201110110877
(71) Applicant: ZTE Corporation, Shenzhen, Guangdong 518057 (CN)
(72) Inventor: HE, Gang, Shenzhen City Guangdong Province 518057 (CN); CHEN, Huazhang, Shenzhen City Guangdong Province 518057 (CN); CUI, Xiaojun, Shenzhen City Guangdong Province 518057 (CN)
(74) Representative: Novagraaf Technologies
(86) International application number: PCT/CN2011/081423
(87) International publication number: WO 2012/146011

(57) **Abstract**

The present invention discloses a power amplifier tube and a power amplification method, wherein, the power amplifier tube includes a High Electron Mobility Transistor (HEMT) power amplifier die and a Lateral Double-Diffused Metal-Oxide Semiconductor (LDMOS) power amplifier die, and the HEMT power amplifier die and the LDMOS power amplifier die are integrated in the same package. The present invention should be configured as a Doherty amplifier, which designs a power tube by using a breakthrough new power amplifier die combination, and can achieve high efficient power amplification on the basis of ensuring a small volume of the power amplifier tube, compared with the existing Doherty amplifiers each of which uses the LDMOS power amplifier die.

## Description

### Technical Field

The present invention relates to the field of Radio Frequency (RF) power amplifier design technologies, and more especially, to a power amplifier tube and a power amplification method.

### Background of the Related Art

With the rapid growth of mobile communication services, the requirements for the performance such as low power consumption, high efficiency and small volume of the corresponding device also increase rapidly, and the efficiency and volume of the base station products have become the competition focus in the industry, and the efficiency improvement of a key component, i.e., the power amplification device that determines the efficiency in the base station has also become a core point.

The RF power amplifiers are widely used in a variety of wireless transmission devices, and efficiency and linearity are two most important indices for the power amplifiers. The design of linear and high-efficient power amplifiers is hotspot and difficulty for the research in this field currently. At present, the Doherty amplifier technology is the most effective and most widely used technology for improving the efficiency of the power amplifier.

The Doherty technology was originally applied in traveling wave tubes to provide high power transmitter for broadcast, and its architecture is simple and high efficient.

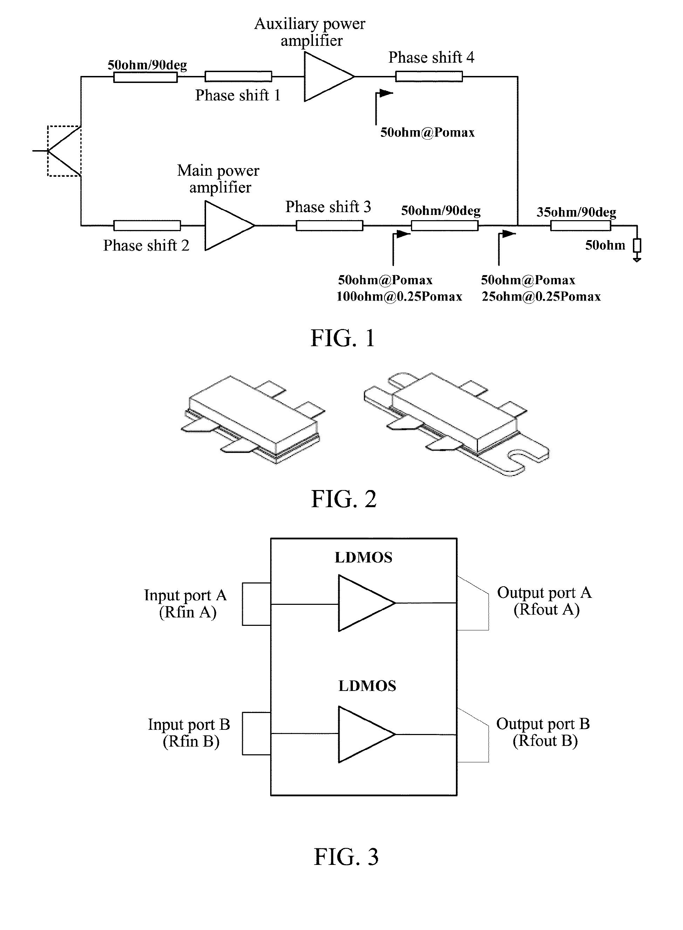

The conventional Doherty structure consists of two power amplifiers, i.e., a main power amplifier (also referred to as a carrier power amplifier) and an auxiliary amplifier (also referred to as a peak power amplifier), wherein, the main power amplifier works in Class B or AB, and the auxiliary power amplifier works in Class C. The two amplifiers do not work in turn, and instead, the main amplifier works all the time, and the auxiliary amplifier does not work until a preset peak power is reached (and thus the auxiliary power amplifier is also referred to as the peak power amplifier). The 90 degree quarter-wavelength line after an output of the main power amplifier plays a role of impedance conversion, and its purpose is to play a role of reducing a apparent impedance of the main power amplifier when the auxiliary power amplifier works, thus ensuring an active load impedance consisting of the auxiliary power amplifier and subsequent circuits when the auxiliary power amplifier works, and therefore, the output current of the main power amplifier increases. Due to the quarter-wavelength line after the output of the main power amplifier, in order to make the outputs of the two power amplifiers be in phase, a 90° phase shift is also needed before the auxiliary power amplifier, as shown in FIG. 1.

The main power amplifier works in Class B, and when a total input signal is relatively small, only the main power amplifier is in a working condition; and when the output voltage of the main power amplifier reaches a peak saturation point, the efficiency of the power amplifier can reach 78.5% in theory. If the excitation is doubled at this time, the main power amplifier will reach saturation when reaching a half of the peak value, the efficiency of the power amplifier also reaches a maximum of 78.5%, and at this time, the auxiliary power amplifier also begins to work together with the main power amplifier. The introduction of the auxiliary power amplifier makes the load reduce from the perspective of the main power amplifier, since the role of the auxiliary amplifier for the load is equivalent to connect negative impedance in series. Therefore, even if the output voltage of the main power amplifier is saturated and constant, the output power continues to increase (the current flowing through the load becomes larger) due to the load reduction. When the excitation peak is reached, the auxiliary power amplifier also reaches the maximum point of its own efficiency, and thus the total efficiency of the two power amplifiers is much higher than the efficiency of a single power amplifier of class B. The maximum efficiency 78.5% of a single power amplifier of class B appears at the peak value, but now the efficiency 78.5% appears at a half of the peak value, and therefore, this system structure can achieve very high efficiency (each amplifier reaches its maximum output efficiency).

The conventional Doherty amplifier is implemented by using two power amplifier tubes which have the same type and are independently packaged as a main power amplifier and a peak power amplifier respectively and combining the two power amplifier tubes. At present, in the industry, the Laterally Diffused Metal Oxide Semiconductor (LDMOS for short) power amplifier tube is most widely used. Since the same type of power amplifier tubes are used, the power supply voltages and bias modes are the same, and thus the design of the bias circuit is simple; and since various power amplifiers are of the same type, the dispersion of the mass production is relatively easy to control. However, the design of the two individually packaged power amplifiers has a relatively large layout area, which is far from meeting the requirements of a small volume.

For the present situation, various power amplifier tube manufacturers have invested a lot of researches and have developed power amplifier tubes with high efficiency and small volume applications for the Doherty technologies, such as the Freescale's two-port device, as shown in FIG. 2. Such devices integrate two independent amplifier tubes (currently both are LDMOS power amplifier dies, and can be used as the Carrier amplifier and the Peak amplifier of the Doherty amplifier to use, and their internal structure is shown in FIG. 3) in one package, which can achieve the Doherty amplifier with a small volume flexibly. However, since it still uses the LDMOS power amplifier tube, and the LDMOS devices have been developed to the eighth generation, although its cost is low, the space of its performance improvement is very limited, which is far from meeting the requirements of green environmental protection. Therefore, how to design power amplifier tubes with a small volume and high efficiency for the Doherty applications is a technical problem to be addressed.

### Summary of the Invention

The technical problem to be solved by the present invention is to provide a power amplifier tube and a power amplification method to achieve high efficient power amplification on the basis of ensuring a small volume of the power amplifier tube.

In order to solve the aforementioned technical problem, the present invention provides a power amplifier tube, which is applied to a Doherty power amplifier apparatus, wherein, the power amplifier tube comprises a High Electron Mobility Transistor (HEMT) power amplifier die and a Lateral Double-Diffused Metal-Oxide Semiconductor (LDMOS) power amplifier die, and both the HEMT power amplifier die and the LDMOS power amplifier die are integrated in the same package.

Optionally, when the power amplifier tube is an amplifier tube of a dual-path structure, one path is configured to use the HEMT power amplifier die and the other path is configured to use the LDMOS power amplifier die.

Optionally, when the power amplifier tube is an amplifier tube of a multi-path structure,
one path is configured to use the HEMT amplifier die and other paths are configured to use the LDMOS die, or
one path is configured to use the LDMOS power amplifier die and other paths are configured to use the HEMT die.

Optionally, the HEMT is based on Gallium Nitride (GaN), and the LDMOS is based on Silicon (Si).

The present invention further provides another power amplifier tube, which is applied to a Doherty power amplifier apparatus, wherein, the power amplifier tube comprises a main power amplifier and auxiliary power amplifier(s), wherein,
both the main power amplifier and the auxiliary power amplifier(s) are integrated in the same package of the power amplifier tube; and
in the main power amplifier and the auxiliary power amplifier(s) in the power amplifier tube, a part of the power amplifiers are configured to use a HEMT device to amplify signal power, and other power amplifier(s) are configured to use a LDMOS device to amplify the signal power.

Optionally, when the power amplifier is an amplifier tube of a dual-path structure, the auxiliary power amplifier is configured to use the HEMT device and the main power amplifier is configured to use the LDMOS device, or the auxiliary amplifier is configured to use the LDMOS device, and the main amplifier is configured to use the HEMT device.

Optionally, when the power amplifier is an amplifier tube of a multi-path structure, a part of the auxiliary amplifiers are configured to use the HEMT device, and other auxiliary power amplifiers and the main power amplifier are configured to use the LDMOS device, or, the main power amplifier is configured to use the HEMT device and the auxiliary power amplifiers are configured to use the LDMOS device, or, the main power amplifier and a part of the auxiliary power amplifiers are configured to use the HEMT device, and other auxiliary amplifiers are configured to use the LDMOS device.

Optionally, the HEMT device is a Gallium Nitride (GaN) based device, and the LDMOS device is a Silicon (Si) based device.

The present invention further provides a power amplification method, comprising:
using a HEMT power amplifier die and a LDMOS power amplifier die to amplify signal power, and both the HEMT power amplifier die and the LDMOS power amplifier die being integrated in the same package of a power amplifier tube.

Optionally, when the power amplifier tube is an amplifier tube of a dual-path structure, one path is configured to use the HEMT power amplifier die and the other path is configured to use the LDMOS power amplifier die.

Optionally, when the power amplifier tube is an amplifier tube of a multi-path structure, one path uses the HEMT power amplifier die and other paths use the LDMOS power amplifier die, or, one path uses the LDMOS power amplifier die and other paths use the HEMT power amplifier die.

Optionally, the method further comprises:
selecting the HEMT device and the LDMOS device according to power amplification parameters of the power amplifier tube.

The present invention further provides another power amplification method, which comprises:
integrating a main power amplifier and auxiliary power amplifier(s) in the same package of a power amplifier tube, wherein, in the main power amplifier and the auxiliary power amplifier(s) in the power amplifier tube, a part of the power amplifier(s) use a HEMT device to amplify signal power, and other power amplifier(s) use a LDMOS device to amplify the signal power.

Optionally, when the power amplifier tube is an amplifier tube of a dual-path structure, the auxiliary power amplifier uses the HEMT device and the main power amplifier uses the LDMOS device, or, the auxiliary power amplifier uses the LDMOS device and the main power amplifier uses the HEMT device.

Optionally, when the power amplifier tube is an amplifier tube of a multi-path structure, a part of the auxiliary power amplifiers use the HEMT device and other auxiliary power amplifiers and the main power amplifier use the LDMOS device, or the main power amplifier uses the HEMT device and the auxiliary power amplifiers use the LDMOS device, or the main power amplifier and a part of the auxiliary power amplifiers use the HEMT device and other auxiliary power amplifiers use the LDMOS device.

The present invention is applied to the Doherty amplifier, designs power tubes by means of using a breakthrough new power amplifier die combination, and can achieve high efficient power amplification on the basis of ensuring a small volume of the power amplifier tube, compared with the existing Doherty amplifiers each of which uses the LDMOS power amplifier die. Since the cost of the GaN based HEMT is 5-10 times higher than that of the LDMOS, compared with the power amplifier tubes whose power amplifier dies are all implemented by using the HEMT, the cost will also reduce while improving the performance.

### Brief Description of Drawings

FIG. 1 is a structural diagram of a conventional Doherty power amplifier;
FIG. 2 is an outline diagram of an individually packaged dual-path power amplifier tube in the related art;
FIG. 3 is a structural diagram of a power amplifier tube of a dual-path structure in the related art; and
FIG. 4 is a structural diagram of a power amplifier tube of a dual-path structure according to the present embodiment.

### Preferred Embodiments of the Present Invention

A power amplifier tube according to an embodiment of the present invention is applied to a Doherty power amplifier apparatus, and this power amplifier tube comprises a HEMT power amplifier die and a LDMOS power amplifier die.

Both the HEMT and the LDMOS power amplifier dies are integrated in the same package.

Optionally, the power amplifier tube can comprise a main power amplifier and auxiliary power amplifier(s). Both the main power amplifier and the auxiliary power amplifier(s) are integrated in the same package of the power amplifier tube; and in the peak power amplifier(s) and the main power amplifier in the power amplifier tube, one or more amplifiers are configured to use the HEMT device to amplify signal power, and other power amplifiers are configured to use the LDMOS device to amplify the signal power.

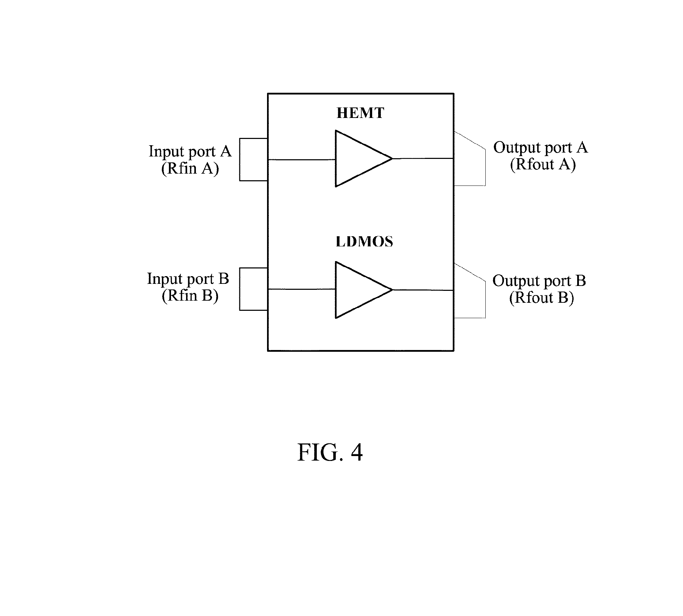

In embodiment one, as shown in FIG. 4, when the power amplifier tube is an amplifier tube of a dual-path structure, one path is configured to use the HEMT die and the other path is configured to use the LDMOS die. Both power amplifier dies of the two paths are integrated in the same package of the power amplifier tube to ensure a small volume of the power amplifier tube while supporting the power amplifier applications with high efficiency.

In embodiment two, when the power amplifier tube is an amplifier tube of a multi-path structure, one path is configured to use the HEMT die and other paths are configured to use the LDMOS die, or, one path is configured to use the LDMOS die and other paths are configured to use the HEMT die. The multi-path power amplifier dies are integrated in the same package of the power amplifier to ensure a small volume of the power amplifier tube while improving the high efficiency of the power amplifier.

The HEMT device is a Gallium Nitride (GaN) based device. The LDMOS device is a Silicon (Si) based device.

A power amplification method according to an embodiment of the present invention comprises: integrating a HEMT and a LDMOS in the same package of an amplifier tube.

Optionally, peak power amplifier(s) and a main power amplifier can be integrated in the same package of the power amplifier tube; and in the peak power amplifier(s) and the main power amplifier in the power amplifier tube, one or more power amplifiers use a HEMT device to amplify signal power, and other power amplifiers use a LDMOS device to amplify the signal power.

In embodiment one, as shown in FIG. 4, when the power amplifier tube is an amplifier tube of a dual-path structure, the peak power amplifier uses the HEMT device and the main power amplifier uses the LDMOS device, or the peak power amplifier uses the LDMOS device and the main power amplifier uses the HEMT device. The auxiliary amplifier and the main amplifier are integrated in the same package of the power amplifier tube to ensure a small volume of the power amplifier tube while improving the high efficiency of the power amplifier.

In embodiment two, when the power amplifier tube is an amplifier tube of a multi-path structure, one or more peak power amplifiers use the HEMT device and other peak power amplifiers and the main power amplifier use the LDMOS device, or, the main power amplifier uses the HEMT device and the peak power amplifiers use the LDMOS device, or the main power amplifier and one or more peak power amplifiers use the HEMT device and other peak power amplifiers use the LDMOS device. The multi-path power amplifier dies are integrated in the same package of the power amplifier tube to ensure a small volume of the power amplifier tube while improving the high efficiency of the power amplifier.

The HEMT device is a Gallium Nitride (GaN) based device. The LDMOS device is a Silicon (Si) based device.

In the present method, the HEMT device and the LDMOS device are selected according to the power amplification parameters of the power amplifier tube.

When designing the Doherty power amplifier, models of the HEMT power amplifier die and the LDMOS power amplifier die are determined according to the required power amplification parameters; the structure (two-path or multi-path structure) of the Doherty power amplifier is determined, the two dies are integrated in the same package structure to complete an internal matching design and tube shell special package, and this Doherty power amplifier is used to amplify a signal.

### Application example:

Since a Doherty power amplifier design with a power being 55W and a peak average ratio being 6dB is applied to the 2.1 GHz UMTS system, it is needed to use a total saturation power being up to at least more than 200W of two independently packaged power amplifier tubes. Combined with existing devices of the power amplifier tube manufacturers, it can be implemented by using two 120W LDMOS power amplifier tubes with a symmetrical Doherty structure, and in accordance with the industry's current device level, the single end stage power amplification efficiency thereof is about 52%; and when it is implemented by the embodiment based on the present invention, the single end stage power amplification efficiency thereof is about 57%, which increases by nearly 10%, but the PCB design layout area can be reduced by nearly a half.

The embodiments of the present invention use a mode of a breakthrough new power amplifier die combination, and integrate the HEMT die and the LDMOS die in a single package to achieve a small volume while improving the amplification efficiency. In specific applications, the advantages of high efficiency for the HEMT power amplifier die can be made full use of to achieve optimal performance by taking the HEMT die as a main power amplifier in the Doherty amplifier. Meanwhile, the advantages such as high maturity and the low cost of the LDMOS power amplifier die technologies can be used to achieve the minimum cost, thus ultimately achieving the perfect combination of performance, cost, and volume. The present invention can be widely used in a variety of Doherty amplifier designs to significantly improve its efficiency indices.

It should be illustrated that, in the case of no conflict, the embodiments and the features in the embodiments of this application could be combined randomly with each other.

Of course, the present invention can have a plurality of other embodiments. Without departing from the spirit and substance of the present invention, those skilled in the art can make various corresponding changes and variations according to the present invention, and all these corresponding changes and variations should belong to the protection scope of the appended claims in the present invention.

A person having ordinary skill in the art can understand that all or a part of steps in the above method can be implemented by programs instructing related hardware, which can be stored in a computer readable storage medium, such as a read-only memory, a disk or a CD-ROM etc. Alternatively, all or a part of steps in the above examples can also be implemented by one or more integrated circuits. Accordingly, each module/unit in the above examples can be implemented in the form of hardware, or can also be implemented in the form of software functional module. The present invention is not limited to any particular form of a combination of hardware and software.

### Industrial Applicability

The above embodiments are applied to the Doherty amplifier, design power tubes by means of using a breakthrough new power amplifier die combination, and can achieve high efficient power amplification on the basis of ensuring a small volume of the power amplifier tube, compared with the existing Doherty amplifiers each of which uses the LDMOS power amplifier die. Since the cost of the GaN based HEMT is 5-10 times higher than that of the LDMOS, compared with the power amplifier tubes whose power amplifier dies are all implemented by using the HEMT, the cost will also reduce while improving the performance.

## Claims

1. A power amplifier tube, which is applied to a Doherty power amplifier apparatus, wherein, the power amplifier tube comprises a High Electron Mobility Transistor (HEMT) power amplifier die and a Lateral Double-Diffused Metal-Oxide Semiconductor (LDMOS) power amplifier die, and both the HEMT power amplifier die and the LDMOS power amplifier die are integrated in a same package.

2. The power amplification tube of claim 1, wherein,
when the power amplifier tube is an amplifier tube of a dual-path structure, one path is configured to use the HEMT power amplifier die and the other path is configured to use the LDMOS power amplifier die.

3. The power amplifier tube of claim 1, wherein, when the power amplifier tube is an amplifier tube of a multi-path structure,
one path is configured to use the HEMT amplifier die and other paths are configured to use the LDMOS die, or
one path is configured to use the LDMOS power amplifier die and other paths are configured to use the HEMT die.

4. The power amplifier tube of any of claims 1-3, wherein,
the HEMT is based on Gallium Nitride (GaN), and the LDMOS is based on Silicon (Si).

5. A power amplifier tube, which is applied to a Doherty power amplifier apparatus, wherein, the power amplifier tube comprises a main power amplifier and auxiliary power amplifier(s), wherein,
both the main power amplifier and the auxiliary power amplifier(s) are integrated in a same package where the power amplifier tube is located;
in the main power amplifier and the auxiliary power amplifier(s) in the power amplifier tube, a part of the power amplifiers are configured to use a High Electron Mobility Transistor (HEMT) device to amplify signal power, and other power amplifier(s) are configured to use a Lateral Double-Diffused Metal-Oxide Semiconductor (LDMOS) device to amplify the signal power.

6. The power amplifier tube of claim 5, wherein,
when the power amplifier is an amplifier tube of a dual-path structure, the auxiliary power amplifier is configured to use the HEMT device and the main power amplifier is configured to use the LDMOS device, or the auxiliary power amplifier is configured to use the LDMOS device, and the main power amplifier is configured to use the HEMT device.

7. The power amplifier tube of claim 5, wherein,
when the power amplifier is an amplifier tube of a multi-path structure, a part of the auxiliary amplifiers are configured to use the HEMT device, and other auxiliary power amplifiers and the main power amplifier are configured to use the LDMOS device, or, the main power amplifier is configured to use the HEMT device and the auxiliary power amplifiers are configured to use the LDMOS device, or, the main power amplifier and a part of the auxiliary power amplifiers are configured to use the HEMT device, and other auxiliary amplifiers are configured to use the LDMOS device.

8. The power amplifier tube of any of claims 5-7, wherein,
the HEMT device is a Gallium Nitride (GaN) based device, and the LDMOS device is a Silicon (Si) based device.

9. A power amplification method, comprising:
using a High Electron Mobility Transistor (HEMT) power amplifier die and a Lateral Double-Diffused Metal-Oxide Semiconductor (LDMOS) power amplifier die to amplify signal power, wherein, both the HEMT power amplifier die and the LDMOS power amplifier die are integrated in a same package of a power amplifier tube.

10. The method of claim 9, wherein, when the power amplifier tube is an amplifier tube of a dual-path structure, one path is configured to use the HEMT power amplifier die and the other path is configured to use the LDMOS power amplifier die.

11. The method of claim 9, wherein, when the power amplifier tube is an amplifier tube of a multi-path structure, one path uses the HEMT power amplifier die and other paths use the LDMOS power amplifier die, or, one path uses the LDMOS power amplifier die and other paths use the HEMT power amplifier die.

12. The method of any of claims 9-11, further comprising:
selecting the HEMT device and the LDMOS device according to power amplification parameters of the power amplifier tube.

13. A power amplification method, comprising:
integrating a main power amplifier and auxiliary power amplifier(s) in a same package where a power amplifier tube is located, wherein, in the main power amplifier and the auxiliary power amplifier(s) in the power amplifier tube, a part of the power amplifier(s) use a High Electron Mobility Transistor (HEMT) device to amplify signal power, and other power amplifier(s) use a Lateral Double-Diffused Metal-Oxide Semiconductor (LDMOS) device to amplify the signal power.

14. The method of claim 13, wherein,
when the power amplifier tube is an amplifier tube of a dual-path structure, the auxiliary power amplifier uses the HEMT device and the main power amplifier uses the LDMOS device, or, the auxiliary power amplifier uses the LDMOS device and the main power amplifier uses the HEMT device.

15. The method of claim 13, wherein,
when the power amplifier tube is an amplifier tube of a multi-path structure, a part of the auxiliary power amplifiers use the HEMT device and other auxiliary power amplifiers and the main power amplifier use the LDMOS device, or the main power amplifier uses the HEMT device and the auxiliary power amplifiers use the LDMOS device, or the main power amplifier and a part of the auxiliary power amplifiers use the HEMT device and other auxiliary power amplifiers use the LDMOS device.
